# EUROPÄISCHE PATENTSCHRIFT

(11) **EP 2 789 214 B1**
(45) Veröffentlichungstag und Bekanntmachung des Hinweises auf die Patenterteilung: **09.03.2016**
(21) Anmeldenummer: 12854548.0
(22) Anmeldetag: 03.12.2012
(51) Int. Cl.: H05K 3/00, H05K 3/46

(54) **VERFAHREN ZUM HERSTELLEN EINER LEITERPLATTE UNTER ENTFERNUNG EINES TEILBEREICHS DERSELBEN SOWIE VERWENDUNG EINES DERARTIGEN VERFAHRENS**
METHOD FOR THE PRODUCTION OF A CIRCUIT BOARD INVOLVING THE REMOVAL OF A SUBREGION THEREOF, AND USE OF SUCH A METHOD
PROCÉDÉ DE PRODUCTION D'UNE CARTE DE CIRCUIT PAR ÉLIMINATION D'UNE ZONE PARTIELLE DE LADITE CARTE, ET UTILISATION D'UN TEL PROCÉDÉ

(30) Priorität: 05.12.2011 AT 6582011
(43) Veröffentlichungstag der Anmeldung: 15.10.2014
(73) Patentinhaber: AT & S Austria Technologie & Systemtechnik Aktiengesellschaft, 8700 Leoben-Hinterberg (AT)
(72) Erfinder: LEITGEB, Markus, A-8793 Trofaiach (AT); WEIDINGER, Gerald, A-8700 Leoben (AT); SCHMID, Gerhard, A-8793 Trofaiach (AT); MARELJIC, Ljubomir, A-8111 Judendorf Strassengel (AT); KARPOWYCH, Volodymyr, A-8053 Graz (AT)
(74) Vertreter: Patentanwaltskanzlei Matschnig & Forsthuber OG
(86) Internationale Anmeldenummer: PCT/AT2012/000302
(87) Internationale Veröffentlichungsnummer: WO 2013/082637

(56) Entgegenhaltungen:
- JP-A- H06 252 559
- JP-A- H08 148 835
- US-A1- 2010 195 967

## Beschreibung

Die vorliegende Erfindung bezieht sich auf ein Verfahren zum Herstellen einer Leiterplatte unter Entfernung eines Teilbereichs derselben, wobei wenigstens zwei Schichten bzw. Lagen der Leiterplatte miteinander verbunden werden und eine Verbindung des zu entfernenden Teilbereichs mit einer benachbart liegenden Lage der Leiterplatte durch Vorsehen bzw. Aufbringen eines ein Anhaften verhindernden Materials verhindert wird und Randbereiche des zu entfernenden Teilbereichs von daran angrenzenden Bereichen der Leiterplatte getrennt werden. Die vorliegende Erfindung bezieht sich darüber hinaus auf eine Verwendung eines derartigen Verfahrens.

Ein Verfahren der eingangs genannten Art ist beispielsweise der WO 2008/098269 A oder der WO 2008/098271 A zu entnehmen, wobei darauf abgezielt wird, in einfacher und zuverlässiger Weise im Rahmen einer Herstellung einer Leiterplatte einen Teilbereich derselben beispielsweise für ein Freilegen eines Elements oder zur Ausbildung einer Freistellung für einen insbesondere nachträglichen Einbau eines Elements zu entfernen. Im Rahmen der Herstellung einer mehrlagigen Leiterplatte ist es bekannt, einzelne Schichten bzw. Lagen einer derartigen Leiterplatte durch Klebe-, Verpress- oder Laminierverfahren miteinander zu verbinden, wobei derartige Schichten bzw. Lagen nicht nur einen unterschiedlichen Aufbau aufweisen sondern üblicherweise auch aus unterschiedlichen Materialien hergestellt sind und/oder in derartigen Schichten bzw. Lagen weitere Elemente, wie beispielsweise aktive oder passive Bauteile eingebaut sind bzw. werden. Gemäß diesem bekannten Verfahren wird darauf abgezielt, im Rahmen der Herstellung einer Leiterplatte bzw. eines Leiterplattenzwischenprodukts oder eines Leiterplattenelements Teilbereiche einer derartigen Leiterplatte bzw. einer Schicht bzw. Lage nach einem Verbindungsvorgang mehrerer Schichten bzw. Lagen zu entfernen, um insbesondere in nachfolgenden Verfahrensschritten beispielsweise weitere Bauteile einsetzen zu können. Gemäß dem bekannten Verfahren wird vorgeschlagen, im Bereich des nachträglich zu entfernenden Teilbereichs der Leiterplatte bzw. einer Schicht oder Lage derselben ein ein Anhaften verhinderndes Material vorzusehen, so dass nach einem Verbinden einer Mehrzahl von Lagen bzw. Schichten der Leiterplatte Randbereiche des zu entfernenden Teilbereichs durchtrennt bzw. getrennt werden und in weiterer Folge unter Berücksichtigung des zwischen dem zu entfernenden Teilbereich und der daran angrenzenden bzw. dazu benachbart liegenden Lage bzw. Schicht vorgesehenen, ein Anhaften verhindernden Materials ein Entfernen dieses Teilbereichs möglich wird. Bei diesem bekannten Verfahren erfolgt eine Entfernung des Teilbereichs im Wesentlichen manuell, wobei insbesondere unter Einsatz von entsprechend feinen Werkzeugen versucht wird, im Bereich der durchtrennten Ränder ein Abheben bzw. Anheben des Teilbereichs und somit ein Entfernen desselben durchzuführen. (siehe z.B. Fig. 7 in JP H08 148825 A oder Fig. 8 in JP H06 252559 A) Insbesondere unter Berücksichtigung der üblicherweise kleinen Abmessungen von Leiterplatten bzw. Leiterplattenelementen und somit geringen Abmessungen eines zu entfernenden Teilbereichs und der feinen Struktur derartiger Leiterplatten besteht durch ein derartiges manuelles Abheben des zu entfernenden Teilbereichs einer Leiterplatte eine Gefahr einer Beschädigung insbesondere daran angrenzender Bereiche der Leiterplatte. Alternativ wird insbesondere bei flexiblen Leiterplatten vorgeschlagen, durch Biegevorgänge einen derartigen zu entfernenden Teilbereich anzuheben, wobei jedoch wiederum die Gefahr einer Beschädigung der herzustellenden Leiterplatte besteht.

Die Erfindung zielt daher darauf ab, ein Verfahren der eingangs genannten Art dahingehend weiterzubilden, dass die oben genannten Nachteile bzw. Probleme vermieden bzw. weitestgehend reduziert werden und insbesondere ein zu entfernender Teilbereich einfach und sicher entfernt werden kann, insbesondere ohne Beschädigungen von daran angrenzenden Bereichen der herzustellenden Leiterplatte zu bewirken.

Zur Lösung dieser Aufgaben ist ein Verfahren der eingangs Art im Wesentlichen dadurch gekennzeichnet, dass eine außen liegende Oberfläche des zu entfernenden Teilbereichs nach einer Trennung bzw. Durchtrennung der Randbereiche mit einem externen Element verbunden wird und dass der zu entfernende Teilbereich durch ein Anheben bzw. Wegbewegen des externen Elements von der benachbarten Lage der Leiterplatte getrennt wird. Dadurch, da erfindungsgemäß eine außen liegende Oberfläche des zu entfernenden Teilbereichs mit einem externen Element verbunden wird, wird im Gegensatz zum bekannten Stand der Technik sichergestellt, dass Beschädigungen von an den zu entfernenden Teilbereich angrenzenden Bereichen der herzustellenden Leiterplatte bei einem Entfernen bzw. Abheben des zu entfernenden Teilbereichs sicher vermieden werden können, da insbesondere keinerlei mechanische Beanspruchung oder Beeinflussung der an den zu entfernenden Teilbereich anschließenden bzw. angrenzenden Bereiche der Leiterplatte auftritt. Erfindungsgemäß wird vorgeschlagen, dass nach einem entsprechenden Verbinden der außen liegenden Oberfläche des zu entfernenden Teilbereichs mit einem externen Element dieser zu entfernende Teilbereich sicher und einfach durch ein Anheben bzw. Wegbewegen des externen Elements von der Leiterplatte, insbesondere von der benachbarten Lage derselben getrennt werden kann, so dass eine derartige Entfernung des zu entfernenden Teilbereichs insgesamt nicht nur einfach und zuverlässig sowie rasch vorgenommen werden kann, sondern insbesondere Beschädigungen von daran anschließenden Bereichen vermieden werden können.

Im Zusammenhang mit der vorliegenden Beschreibung wird festgehalten, dass der hierin verwendete Ausdruck "Leiterplatte" nicht nur eine im Wesentliche fertig gestellte mehrlagige Leiterplatte bezeichnen soll, sondern dass eine erfindungsgemäß vorgesehene Entfernung eines Teilbereichs einer derartigen Leiterplatte auch in unterschiedlichen Zwischenschritten einer Herstellung vorgesehen sein kann, so dass unter dem allgemeinen Ausdruck Leiterplatte auch Leiterplattenelemente oder Leiterplatten-Zwischenprodukte während unterschiedlicher Verfahrensschritte im Rahmen einer insbesondere mehrstufigen Herstellung einer Leiterplatte zu verstehen sind.

Gemäß einer bevorzugten Ausführungsform wird vorgeschlagen, dass in bzw. an der Schicht aus dem ein Anhaften bzw. Verkleben verhindernden Material in einem Rand- bzw. Teilbereich eine Rissbildung und/oder eine Ablösung von dem zu entfernenden Teilbereich der Leiterplatte induziert wird und nachfolgend der zu entfernende Teilbereich entfernt wird. Dadurch gelingt nachfolgend in einfacher und zuverlässiger Weise eine Entfernung des zu entfernenden Teilbereichs, da durch die induzierte Rissbildung oder Ablösung in einem Rand- bzw. Teilbereich eine gegebenenfalls verbleibende geringfügige Adhäsion bzw. Anhaftung zwischen dem zu entfernenden Teilbereich und der daran angrenzenden bzw. dazu benachbarten Schicht bzw. Lage der Leiterplatte zumindest in einem Teilbereich überwunden wird und somit ein einfaches und im Wesentlichen selbsttätiges Abheben bzw. Entfernen des zu entfernenden Teilbereichs vorgenommen werden kann.

Eine besonders einfache und zuverlässige Unterstützung der Entfernung des zu entfernenden Teilbereichs wird gemäß einer weiters bevorzugten Ausführungsform des erfindungsgemäßen Verfahrens dadurch erzielt, dass die Rissbildung und/oder Ablösung von dem zu entfernenden Teilbereich der Leiterplatte in bzw. an der Schicht aus dem ein Anhaften verhindernden Material durch ein Einbringen bzw. Ausbilden von durch eine ungleichmäßige Beanspruchung des zu entfernenden Teilbereichs hervorgerufenen Verwindungen desselben hervorgerufen wird bzw. werden. Eine derartige ungleichmäßige Beanspruchung des zu entfernenden Teilbereichs lässt sich ohne Beschädigungen der herzustellenden Leiterplatte in den zu entfernenden Teilbereich einbringen, so dass ein Abheben bzw. Ablösen und Entfernen des zu entfernenden Teilbereichs unterstützt bzw. vereinfacht wird.

Gemäß einer weiters bevorzugten Ausführungsform des erfindungsgemäßen Verfahrens wird vorgeschlagen, dass die Verbindung des externen Elements mit der außen liegenden Oberfläche des zu entfernenden Teilbereichs durch ein Kleben, Schweißen, Löten, Bonden, Reibschweißen oder dgl. vorgenommen wird. Derart gelingt eine einfache und zuverlässige Verbindung eines derartigen externen Elements mit der außen liegenden Oberfläche des zu entfernenden Teilbereichs, wobei die genannten Verfahrensschritte in einfacher Weise im Rahmen eines Herstellungsverfahrens einer Leiterplatte integriert werden können.

Zur weiteren Vereinfachung und Beschleunigung einer Entfernung eines derartigen zu entfernenden Teilbereichs einer Leiterplatte und somit zur Beschleunigung des Herstellungsverfahrens einer derartigen Leiterplatte wird gemäß einer weiters bevorzugten Ausführungsform vorgeschlagen, dass die Verbindung des externen Elements mit der außen liegenden Oberfläche des zu entfernenden Teilbereichs automatisiert vorgenommen wird.

Darüber hinaus wird zur weiteren Beschleunigung des Herstellungsverfahrens insbesondere im Zusammenhang mit der Entfernung des zu entfernenden Teilbereichs vorgeschlagen, dass die Entfernung des zu entfernenden Teilbereichs automatisiert vorgenommen wird, wie dies einer weiters bevorzugten Ausführungsform des erfindungsgemäßen Verfahrens entspricht.

Für eine einfache und zuverlässige Durchtrennung der Randbereiche des zu entfernenden Teilbereichs wird gemäß einer weiters bevorzugten Ausführungsform vorgeschlagen, dass die Randbereiche des zu entfernenden Teilbereichs in an sich bekannter Weise durch ein Fräsen, Ritzen, Schneiden, insbesondere Laserschneiden definiert und/oder getrennt bzw. durchtrennt werden.

Für ein einfaches Entfernen des zu entfernenden Teilbereichs wird gemäß einer weiters bevorzugten Ausführungsform vorgeschlagen, dass in an sich bekannter Weise das ein Anhaften verhindernde Material von einer wachsartigen Paste gebildet wird, welche während eines Verbindungsvorgangs von wenigstens zwei Schichten bzw. Lagen der Leiterplatte ein Anhaften des nachfolgend zu entfernenden Teilbereichs an der benachbart liegenden Lage der Leiterplatte verhindert. Derart kann insbesondere mit geringem Kraftaufwand nach einer Verbindung zwischen dem externen Element und der äußeren bzw. außen liegenden Oberfläche des zu entfernenden Teilbereichs dieser entfernt werden.

Zur weiteren Vereinfachung und Beschleunigung des erfindungsgemäßen Verfahrens im Zusammenhang mit der Entfernung des zu entfernenden Teilbereichs sowie einer Automatisierung desselben wird gemäß einer weiters bevorzugten Ausführungsform vorgeschlagen, dass die Verbindung der außen liegenden Oberfläche des zu entfernenden Teilbereichs mit dem externen Element durch eine Überwachungseinrichtung geregelt bzw. gesteuert wird, welche insbesondere automatisiert die Position des zu entfernenden Teilbereichs durch ein Bildbearbeitungsverfahren ermittelt.

Im Rahmen der Herstellung von Leiterplatten ist es bekannt, gegebenenfalls eine größere Anzahl von insbesondere identen herzustellenden Leiterplatten in einem gemeinsamen Rahmen- bzw. Trägerelement anzuordnen und eine Mehrzahl von Be- bzw. Verarbeitungsschritten insbesondere im Wesentlichen gleichzeitig an der Mehrzahl von Leiterplatten bzw. Leiterplattenelementen durchzuführen. In diesem Zusammenhang wird gemäß einer weiters bevorzugten Ausführungsform des erfindungsgemäßen Verfahrens vorgeschlagen, dass eine Mehrzahl von zu entfernenden Teilbereichen insbesondere von einer Mehrzahl von Leiterplatten unter Verwendung eines gemeinsamen externen Elements im wesentlichen gleichzeitig entfernt wird, so dass derart eine weitere Vereinfachung bzw. Beschleunigung bei der Entfernung einer Mehrzahl von zu entfernenden Teilbereichen aus einer entsprechenden Vielzahl von Leiterplatten erzielbar ist. Alternativ und/oder zusätzlich ist es erfindungsgemäß möglich, eine Mehrzahl von zu entfernenden Teilbereichen aus einer Leiterplatte mit einem gemeinsamen externen Element zu entfernen.

Für eine einfache und sichere Verbindung einer derartigen Mehrzahl von zu entfernenden Teilbereichen wird gemäß einer weiters bevorzugten Ausführungsform vorgeschlagen, dass das gemeinsame externe Element jeweils durch eine Klebeverbindung mit den zu entfernenden Teilbereichen gekoppelt wird, wobei der Kleber insbesondere jeweils entsprechend den Abmessungen der zu entfernenden Teilbereiche auf diese aufgebracht wird.

Zur Bereitstellung einer ausreichenden anhaftenden Verbindung bzw. Kraft zwischen der außen liegenden Oberfläche des zu entfernenden Teilbereichs sowie dem externen Element wird darüber hinaus vorgeschlagen, dass der Kleber für eine Verbindung der außen liegenden Oberfläche des zu entfernenden Teilbereichs mit dem externen Element einem Aushärtevorgang unterworfen wird, wie dies einer weiters bevorzugten Ausführungsform des erfindungsgemäßen Verfahrens entspricht.

Zur gleichzeitigen Entfernung einer Vielzahl von zu entfernenden Teilbereichen aus einer entsprechenden Vielzahl von insbesondere in einem gemeinsamen Rahmen- bzw. Trägerelement angeordneten Leiterplatten bzw. Leiterplattenelementen wird darüber hinaus bevorzugt vorgeschlagen, dass das gemeinsame Element von einer flächigen Materialschicht, insbesondere einer Folie gebildet wird.

Gemäß einer alternativen Ausführungsform des erfindungsgemäßen Verfahrens wird vorgeschlagen, dass das externe Element von einem Draht oder wenigstens einem stift- bzw. stabartigen Element, insbesondere aus Kunststoff, gebildet wird, welcher(s) mittels Löten, Schweißen, Reibschweißen, Bonden oder Kleben mit der außen liegenden Oberfläche des zu entfernenden Teilbereichs verbunden wird. Eine Verwendung eines Drahts bzw. stabartigen Elements bzw. Kunststoffstifts als externes Element stellt ein einfaches und entsprechend einfach verfügbares externes Element zur Verfügung. Es lässt sich darüber hinaus die erfindungsgemäß vorgesehene Verbindung des von einem Draht bzw. wenigstens einem stabartigen Element gebildeten externen Elements mit der außen liegenden Oberfläche des zu entfernenden Teilbereichs insbesondere mit im Rahmen der Herstellung bzw. Be- oder Verarbeitung einer Leiterplatte für sich gesehen bekannten Verfahrensschritten durchführen, welche somit einfach in ein erfindungsgemäßes Herstellungsverfahren einer derartigen Leiterplatte integrierbar sind.

Für eine zuverlässige Positionierung und nachfolgende Entfernung des zu entfernenden Teilbereichs wird darüber hinaus vorgeschlagen, dass das externe Element durch eine automatisierte Handhabungseinrichtung an der außen liegenden Oberfläche des zu entfernenden Teilbereichs positioniert wird und nach einer Verbindung mit der außen liegenden Oberfläche eine automatisierte Entfernung des zu entfernenden Teilbereichs durchgeführt wird, wie dies einer weiters bevorzugten Ausführungsform des erfindungsgemäßen Verfahrens entspricht.

Wie oben bereits angeführt, wird darüber hinaus erfindungsgemäß vorgeschlagen, das erfindungsgemäße Verfahren oder eine bevorzugte Ausführungsform hievon zur Herstellung einer mehrlagigen Leiterplatte bzw. eines mehrlagigen Leiterplattenelements oder Leiterplatten-Zwischenprodukts einzusetzen bzw. zu verwenden.

Insbesondere im Zusammenhang mit einer derartigen erfindungsgemäßen Verwendung wird darüber hinaus bevorzugt vorgeschlagen, das erfindungsgemäße Verfahren zur Erzeugung von Hohlräumen, insbesondere dreidimensionalen Hohlräumen bzw. Kavitäten in einer Leiterplatte zu verwenden.

Weitere bevorzugte Verwendungsmöglichkeiten des erfindungsgemäßen Verfahrens liegen in einer Erzeugung wenigstens eines Kanals in einer Leiterplatte, einer Freistellung wenigstens eines Elements, insbesondere Registrierelements im Inneren bzw. in Innenlagen einer mehrlagigen Leiterplatte, einer Herstellung von abgesetzten und/oder stufenförmig ausgebildeten Teilbereichen einer Leiterplatte und/oder einer Herstellung einer starr-flexiblen Leiterplatte.

Die Erfindung wird nachfolgend anhand von in der beiliegenden Zeichnung schematisch dargestellten Ausführungsbeispielen des erfindungsgemäßen Verfahrens näher erläutert. In dieser zeigen:
Fig. 1 einen schematischen Schnitt durch einen Teilbereich einer Leiterplatte, wobei bei der Durchführung des erfindungsgemäßen Verfahrens Randbereiche eines zu entfernenden Teilbereichs bereits durchtrennt wurden;
Fig. 2 einen weiteren Verfahrensschritt des erfindungsgemäßen Verfahrens nachfolgend auf Fig. 1, wobei eine Verbindung der außen liegenden Oberfläche des zu entfernenden Teilbereichs mit einem externen Element vorbereitet bzw. durchgeführt wird;
Fig. 3 eine schematische Darstellung eines weiteren Verfahrensschritts, wobei der zu entfernende Teilbereich nach einer Verbindung mit dem externen Element entfernt wird;
Fig. 4 in einer zu Fig. 2 ähnlichen Darstellung einen Verfahrensschritt eines abgewandelten Verfahrens, wobei ein externes Element von einem mit der außen liegenden Oberfläche eines zu entfernenden Teilbereichs zu verbindenden Draht gebildet wird;
Fig. 5 in einer zu Fig. 3 ähnlichen Darstellung die Entfernung des zu entfernenden Teilbereichs;
Fig. 6 in einer wiederum zu Fig. 4 ähnlichen Darstellung eine Verbindung der außen liegenden Oberfläche eines zu entfernenden Teilbereichs mit einem externen Element;
Fig. 7 in einer wiederum zu Fig. 5 ähnlichen Darstellung eine Entfernung des zu entfernenden Teilbereichs; und
Fig. 8 schematisch entsprechend dem erfindungsgemäßen Verfahren und in einer vereinfachten Darstellung die Induzierung einer Rissbildung in der ein Anhaften bzw. Verkleben verhindernden Schicht in einem Teilbereich unterhalb des zu entfernenden Teilbereichs, wobei in Fig. 8a schematisch die Einbringung einer ungleichmäßigen Belastung zur Rissbildung angedeutet ist, während in Fig. 8b eine Rissbildung durch ein Verwinden des zu entfernenden Teilbereichs angedeutet ist.

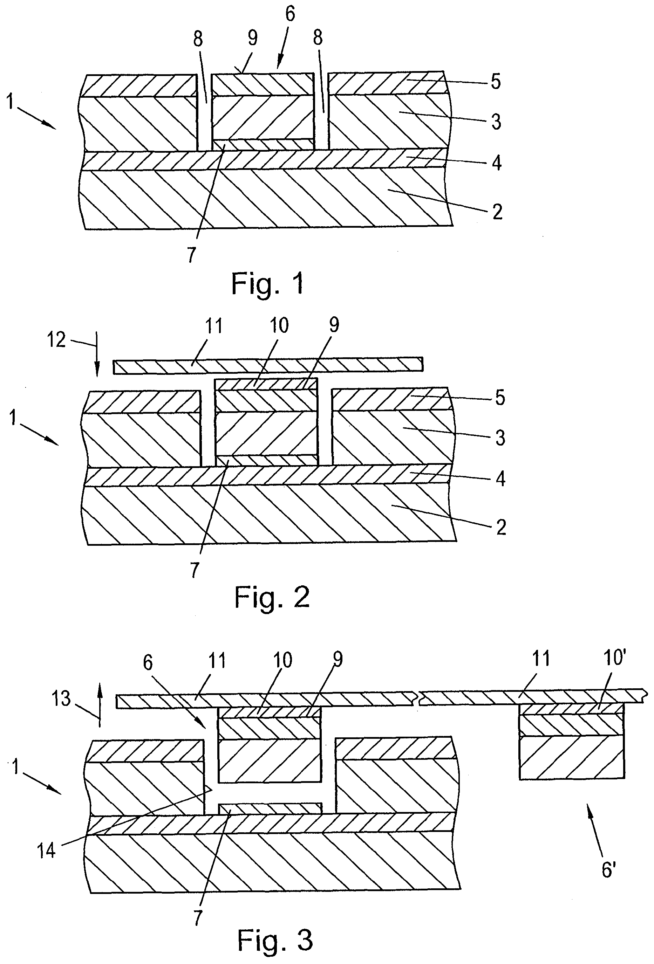

In dem in Fig. 1 dargestellten Verfahrensschritt ist eine Leiterplatte bzw. ein Teilbereich derselben mit 1 bezeichnet, wobei ersichtlich ist, dass die Leiterplatte 1 von einer Mehrzahl von Schichten bzw. Lagen gebildet wird, wobei beispielsweise Schichten 2 und 3 jeweils aus einem isolierenden Material, beispielsweise FR4 bestehen, während dazwischen liegende Lagen 4 und 5 aus einem leitenden bzw. leitfähigen Material, insbesondere Kupfer bestehen und gegebenenfalls strukturiert sind.

Es wird wiederum darauf hingewiesen, dass die allgemein in Fig. 1 dargestellte Leiterplatte 1 nicht nur eine im Wesentlichen fertig gestellte Leiterplatte darstellen kann, sondern gegebenenfalls auch ein Leiterplattenelement oder Leiterplatten-Zwischenprodukt, welches insbesondere weiteren Be- oder Verarbeitungsschritten unterworfen wird. Darüber hinaus wird auf allgemein bekannte Verfahrensschritte zur Herstellung einer derartigen mehrlagigen Leiterplatte und beispielsweise Strukturierung der leitenden Schichten bzw. Lagen 4 oder 5 nicht näher eingegangen, da diese für sich gesehen bekannt sind.

In Fig. 1 ist darüber hinaus gezeigt, dass ein allgemein mit 6 bezeichneter und in weiterer Folge zu entfernender Teilbereich der Leiterplatte 1 unter Vermittlung einer Schicht 7 aus einem ein Anhaften verhindernden Material an die daran angrenzende bzw. benachbart liegende Schicht bzw. Lage 4 während des nicht näher beschriebenen Herstellungsvorgangs der mehrlagigen Leiterplatte 1 anschließt, so dass nach einer in der Darstellung von Fig. 1 bereits durchgeführten Durchtrennung der Randbereiche des zu entfernenden Teilbereichs 6, wie sie durch die getrennten bzw. durchtrennten Bereiche 8 angedeutet sind, der zu entfernende Teilbereich 6 in einfacher Weise von der daran angrenzenden bzw. benachbart liegenden Schicht bzw. Lage 4 getrennt werden kann.

Um insbesondere mechanische Beschädigungen von an den zu entfernenden Teilbereich 6 angrenzenden Bereichen der Leiterplatte 1 zu vermeiden, wird, wie dies in Fig. 2 dargestellt ist, auf einer außen liegenden Oberfläche 9 des zu entfernenden Teil-bereichs ein Kleber 10 aufgebracht, wobei die außen liegende Oberfläche 9, auf welcher der Kleber 10 vorgesehen ist, in weiterer Folge mit einer Folie 11 verbunden wird, wie dies durch den Pfeil 12 in Fig. 2 angedeutet ist. Die Folie 11 stellt hierbei ein externes Element dar, welches unter Vermittlung des Klebers 10 mit dem zu entfernenden Teilbereich und insbesondere der außen liegenden Oberfläche 9 davon gekoppelt wird. Für ein ordentliches bzw. zuverlässiges Anhaften des von der Folie 11 gebildeten externen Elements kann beispielsweise ein Aushärtvorgang des Klebers 10 durchgeführt werden.

Nach einer derartigen Verbindung zwischen dem zu entfernenden Teilbereich 6 und insbesondere der außen liegenden Oberfläche 9 hiervon und dem von einer Folie 11 gebildeten externen Element erfolgt ein einfaches und zuverlässiges Entfernen bzw. Abheben des zu entfernenden Teilbereichs 6 durch ein Abheben bzw. Wegbewegen des von der Folie 11 gebildeten externen Elements in Richtung des Pfeils 13, wie dies in Fig. 3 ersichtlich ist, wodurch ein Hohlraum 14 bzw. abgesetzter oder freigestellter Bereich in der Leiterplatte 1 hergestellt wird. Der zu entfernende Teilbereich 6 kann durch Vorsehen des ein Anhaften verhindernden Materials 7 leicht abgehoben bzw. entfernt werden, so dass jegliche mechanische Beanspruchungen bzw. Beschädigungen von an den zu entfernenden Teilbereich 6 angrenzenden Bereichen der Leiterplatte bzw. des Leiterplattenelements 1 zuverlässig vermieden werden können.

In Fig. 3 ist darüber hinaus schematisch angedeutet, dass eine Mehrzahl von derartigen Leiterplatten bzw. Leiterplattenelementen nebeneinander beispielsweise in einem nicht näher dargestellten Rahmen- bzw. Trägerelement angeordnet ist, so dass durch Vorsehen eines entsprechend große Abmessungen aufweisenden externen Elements 11 gleichzeitig eine entsprechende Vielzahl von zu entfernenden Teilbereichen entfernt werden kann, wobei ein derartiger zusätzlicher, zu entfernender Teilbereich in Fig. 3 schematisch mit 6' angedeutet ist. Dieser zu entfernende Teilbereich ist ebenfalls über eine Klebeschicht 10' mit dem von einer Folie gebildeten externen Element 11 verbunden.

Es lässt sich somit in einfacher Weise beispielsweise eine Vielzahl von zu entfernenden Teilbereichen aus einer entsprechenden Vielzahl von beispielsweise in einem gemeinsamen Rahmen- bzw. Trägerelement angeordneten Leiterplatten bzw. Leiterplattenelementen 1 entfernen. In ähnlicher Weise kann durch ein gemeinsames externes Element 11 eine Mehrzahl von zu entfernenden Teilbereichen 6 aus einer Leiterplatte 1 entfernt werden.

Der Kleber 10 für eine Verbindung zwischen der außen liegenden Oberfläche 9 des zu entfernenden Teilbereichs 6 und dem externen Element 11 wird im Wesentlichen lediglich entsprechend den Abmessungen der außen liegenden Oberfläche 9 des zu entfernenden Teilbereichs 6 aufgebracht, so dass ein Anhaften des externen Elements 11 an weiteren, an den zu entfernenden Teilbereich 6 angrenzenden Bereichen der Leiterplatte 1 vermieden wird oder eine nachträgliche Reinigung ebenfalls entfallen kann.

Als Kleber kann beispielsweise ein unter Wärme härtender Einkomponentenkleber verwendet werden, welcher mittels eines Druck- oder Dosierverfahrens, beispielsweise Siebdruck, auf die außen liegende Oberfläche 9 des zu entfernenden Teilbereichs 6 aufgebracht, insbesondere aufgedruckt wird. Als externes Element 11 kann beispielsweise eine steife Deckfolie zur Entfernung des zu entfernenden Teilbereichs 6 oder gegebenenfalls eine Mehrzahl derselben eingesetzt werden.

Anstelle eines Aufbringens eines Klebers und eines nachfolgenden Verbindens mit einem von einer Folie 11 gebildeten externen Element kann auch beispielsweise ein Klebeband eingesetzt werden, wobei durch ein Abziehen des Klebebands und durch die geringe Anhaftung des zu entfernenden Teilbereichs 6 an der darunter liegenden bzw. benachbart liegenden Schicht 4 durch Vorsehen des ein Anhaften verhindernden Materials 7 ebenfalls sicher und einfach ein Abheben bzw. Entfernen des zu entfernenden Teilbereichs 6 vorgenommen werden kann, ohne mechanische Einwirkungen oder Beschädigungen an daran angrenzenden Bereichen der Leiterplatte 1 befürchten zu müssen.

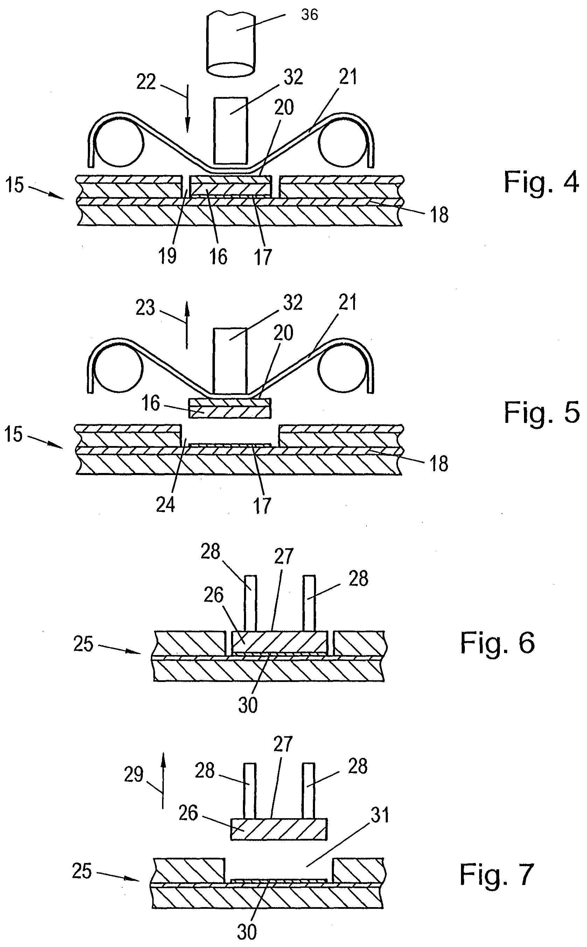

In Fig. 4 und 5 ist eine abgewandelte Ausführungsform eines Verfahrens zur Entfernung eines Teilbereichs einer Leiterplatte dargestellt. In Fig. 4 ist ersichtlich, dass wiederum eine schematisch mit 15 angedeutete mehrlagige Leiterplatte in nicht näher dargestellten vorangehenden Verfahrensschritten hergestellt wurde, wobei ein zu entfernender Teilbereich 16 wiederum unter Vermittlung einer ein Anhaften verhindernden Schicht 17 mit einer darunter liegenden Schicht bzw. Lage 18 anschließt. Ähnlich wie bei der Darstellung gemäß Fig. 1 sind Randbereiche des zu entfernenden Teilbereichs 16 bereits entfernt bzw. durchtrennt, wie dies durch 19 angedeutet ist.

Für eine Kopplung mit der außen liegenden Oberfläche 20 des zu entfernenden Teilbereichs 16 ist als externes Element ein Draht 21 vorgesehen, welcher durch eine stempelartige Vorrichtung 32 im Sinn des Pfeils 22 mit der außen liegenden Oberfläche 20 des zu entfernenden Teilbereichs 16 verbunden wird, wobei hiefür beispielsweise ein Löten, Schweißen oder Bonden eingesetzt werden kann.

Nach einer Kopplung zwischen dem von dem Draht 21 gebildeten externen Element und der außen liegenden Oberfläche 20 des zu entfernenden Teilbereichs 16 wird dieser durch ein Anheben des Drahts 21 im Sinn des Pfeils 23 entfernt, so dass ebenso wie bei der vorangehenden Ausführungsform nach der Entfernung des zu entfernenden Teilbereichs 16 ein Hohlraum 24 in der Leiterplatte bzw. dem Leiterplattenelement 15 zur Verfügung gestellt werden kann.

Für ein im Wesentlichen automatisiertes Positionieren des externen Elements 21 auf dem zu entfernenden Teilbereich 16 ist in Fig. 4 schematisch mit 36 eine Überwachungseinrichtung angedeutet, welche beispielsweise unter anderem eine Kamera enthält. Durch ein an sich bekanntes Bildbearbeitungsverfahren kann die Position des zu entfernenden Teilbereichs 16 im Wesentlichen automatisiert bestimmt werden und es kann derart ebenfalls automatisiert eine Positionierung und Festlegung des von einem Draht gebildeten externen Elements 21 an der außen liegenden Oberfläche 20 des zu entfernenden Teilbereichs 16 durchgeführt werden.

Es lässt sich somit in einem im Wesentlichen automatisierten Herstellungsverfahren einer mehrlagigen Leiterplatte einfach und zuverlässig ein zu entfernender Teilbereich 16 entfernen, um derart beispielsweise einen dreidimensionalen Hohlraum 24 oder einen Kanal in einer derartigen Leiterplatte 15 bereitzustellen.

Alternativ kann eine derartige Entfernung des zu entfernenden Teilbereichs 16 beispielsweise zur Bereitstellung eines in die mehrlagige Leiterplatte 15 integrierten Elements vorgesehen sein.

In Fig. 6 und 7 ist eine weitere abgewandelte Ausführungsform eines Verfahrens zur Entfernung eines Teilbereichs aus einer Leiterplatte 25 dargestellt, wobei beispielsweise ähnlich zu der Darstellung gemäß Fig. 4 bei dem in Fig. 6 dargestellten Verfahrensschritt ein zu entfernender Teilbereich 26 an seiner außen liegenden Oberfläche 27 mit stab- bzw. stangenförmigen Elementen 28 verbunden wird, welche beispielsweise ähnlich der Ausführungsform gemäß Fig. 4 wiederum im Rahmen eines automatisierten Überwachungsverfahrens mit der außen liegenden Oberfläche 27 des zu entfernenden Teilbereichs 26 verbunden werden. Ein derartiges Verbinden kann beispielsweise durch ein Kleben, Schweißen, Löten oder Bonden vorgenommen werden. Alternativ kann ein Reibschweißen eines Kunststoffelements 28, welches beispielsweise aus Polyethylen oder Polypropylen ausgebildet ist, für eine Verbindung mit der außen liegenden Oberfläche 27 des zu entfernenden Teilbereichs 26 vorgesehen sein.

Nach der Verbindung mit der außen liegenden Oberfläche 27 des zu entfernenden Teilbereichs 26 erfolgt ähnlich wie bei den vorangehenden Ausführungsformen durch ein Anheben bzw. Wegbewegen der externen Elemente 28 eine Entfernung des zu entfernenden Teilbereichs entsprechend dem Pfeil 29 zur Ausbildung bzw. Bereitstellung eines Hohlraums bzw. einer Freistellung 31, wobei eine ein Anhaften verhindernde Schicht bzw. Lage bei dieser Ausführungsform mit 30 bezeichnet ist.

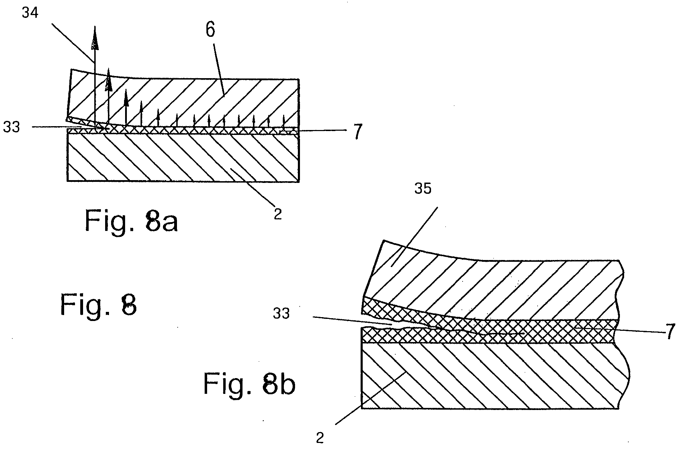

In Fig. 8, in welcher zur Vereinfachung die Bezugszeichen der Fig. 1 beibehalten wurden und eine gegebenenfalls mehrlagige Struktur nicht im Detail dargestellt ist, wird eine Rissbildung in dem ein Anhaften bzw. Verkleben verhindernden Material 7 induziert, wie dies in Fig. 8a und 8b jeweils mit 33 angedeutet ist. Eine derartige Rissbildung 33, welche in weiterer Folge ein einfaches Entfernen des zu entfernenden Teilbereichs 6 von der Schicht 2 der herzustellenden Leiterplatte ermöglicht, kann beispielsweise durch ein Einbringen von unterschiedlichen Beanspruchungen auf den zu entfernenden Teilbereich 6 bewirkt werden, wie dies schematisch durch die unterschiedliche Beanspruchungen andeutenden Pfeile 34 in Fig. 3a gezeigt ist, wobei ein derartiges Einbringen von unterschiedlichen Beanspruchungen beispielsweise durch eine unterschiedliche Krafteinbringung insbesondere in einem Randbereich bei einem Entfernen unter Verwendung eines Drahts gemäß Fig. 5 oder bei einem Einsatz von stabartigen Elementen 28 gemäß Fig. 7 erfolgen kann.

Alternativ oder zusätzlich kann, wie dies in Fig. 8b angedeutet ist, eine Rissbildung 33 durch ein Verwinden eines Randbereichs 35 des zu entfernenden Teilbereichs 6 induziert werden, wodurch ebenfalls in weiterer Folge der zu entfernende Teilbereich 6 einfach von der Leiterplatte bzw. von der darunter liegenden bzw. angrenzenden Schicht oder Lage 2 entfernt werden kann.

Anstelle der dargestellten Hohlräume 14 bzw. 24 bzw. 31, welche im Wesentlichen geradlinige Außenbegrenzungen aufweisen, kann beispielsweise durch ein mehrstufiges Entfernen von mehreren zu entfernenden Teilbereichen in übereinander angeordneten Schichten bzw. Lagen einer mehrlagigen Leiterplatte auch ein abgesetzter und/oder stufenförmig ausgebildeter Teilbereich hergestellt werden.

## Patentansprüche

1. Verfahren zum Herstellen einer Leiterplatte (1, 15, 25) unter Entfernung eines Teilbereichs (6, 6', 16, 26) derselben, wobei wenigstens zwei Schichten bzw. Lagen (2, 3, 4, 5) der Leiterplatte (1, 15, 25) miteinander verbunden werden und eine Verbindung des zu entfernenden Teilbereichs (6, 6', 16, 26) mit einer benachbart liegenden Lage der Leiterplatte (1, 15, 25) durch Vorsehen bzw. Aufbringen eines ein Anhaften verhindernden Materials (7, 17, 30) verhindert wird und Randbereiche des zu entfernenden Teilbereichs (6, 6', 16, 26) von daran angrenzenden Bereichen der Leiterplatte (1, 15, 25) getrennt werden, **dadurch gekennzeichnet, dass** eine außen liegende Oberfläche (9, 20, 27) des zu entfernenden Teilbereichs (6, 6', 16, 26) nach einer Trennung bzw. Durchtrennung (8, 19) der Randbereiche mit einem externen Element (11, 21, 28) verbunden wird und dass der zu entfernende Teilbereich (6, 6', 16, 26) durch ein Anheben bzw. Wegbewegen des externen Elements (11, 21, 28) von der benachbarten Lage der Leiterplatte (1, 15, 25) getrennt wird.

2. Verfahren nach Anspruch 1, **dadurch gekennzeichnet, dass** in bzw. an der Schicht (7) aus dem ein Anhaften bzw. Verkleben verhindernden Material in einem Rand- bzw. Teilbereich eine Rissbildung (33) und/oder eine Ablösung von dem zu entfernenden Teilbereich (6) der Leiterplatte (1) induziert wird und nachfolgend der zu entfernende Teilbereich (6) entfernt wird.

3. Verfahren nach Anspruch 2, **dadurch gekennzeichnet, dass** die Rissbildung (33) und/oder Ablösung von dem zu entfernenden Teilbereich (6) der Leiterplatte (1) in bzw. an der Schicht (7) aus dem ein Anhaften verhindernden Material durch ein Einbringen bzw. Ausbilden von durch eine ungleichmäßige Beanspruchung des zu entfernenden Teilbereichs (6) hervorgerufenen Verwindungen desselben hervorgerufen wird bzw. werden.

4. Verfahren nach Anspruch 1, 2 oder 3, **dadurch gekennzeichnet, dass** die Verbindung des externen Elements (11, 21, 28) mit der außen liegenden Oberfläche (9, 20, 27) des zu entfernenden Teilbereichs (6, 6', 16, 26) durch ein Kleben, Schweißen, Löten, Bonden, Reibschweißen oder dgl. vorgenommen wird.

5. Verfahren nach einem der Ansprüche 1 bis 4, **dadurch gekennzeichnet, dass** die Verbindung des externen Elements (11, 21, 28) mit der außen liegenden Oberfläche (9, 20, 27) des zu entfernenden Teilbereichs (6, 6', 16, 26) automatisiert vorgenommen wird.

6. Verfahren nach einem der Ansprüche 1 bis 5, **dadurch gekennzeichnet, dass** die Entfernung des zu entfernenden Teilbereichs (6, 6', 16, 26) automatisiert vorgenommen wird.

7. Verfahren nach einem der Ansprüche 1 bis 6, **dadurch gekennzeichnet, dass** die Randbereiche des zu entfernenden Teilbereichs (6, 6', 16, 26) in an sich bekannter Weise durch ein Fräsen, Ritzen, Schneiden, insbesondere Laserschneiden definiert und/oder getrennt bzw. durchtrennt werden.

8. Verfahren nach einem der Ansprüche 1 bis 7, **dadurch gekennzeichnet, dass** in an sich bekannter Weise das ein Anhaften verhindernde Material (7, 17, 30) von einer wachsartigen Paste gebildet wird, welche während eines Verbindungsvorgangs von wenigstens zwei Schichten bzw. Lagen der Leiterplatte ein Anhaften des nachfolgend zu entfernenden Teilbereichs (6, 6', 16, 26) an der benachbart liegenden Lage der Leiterplatte (1, 15, 25) verhindert.

9. Verfahren nach einem der Ansprüche 1 bis 8, **dadurch gekennzeichnet, dass** die Verbindung der außen liegenden Oberfläche (20) des zu entfernenden Teilbereichs (16) mit dem externen Element (21) durch eine Überwachungseinrichtung (36) geregelt bzw. gesteuert wird, welche insbesondere automatisiert die Position des zu entfernenden Teilbereichs (16) durch ein Bildbearbeitungsverfahren ermittelt.

10. Verfahren nach einem der Ansprüche 1 bis 9, **dadurch gekennzeichnet, dass** eine Mehrzahl von zu entfernenden Teilbereichen (6, 6') insbesondere von einer Mehrzahl von Leiterplatten (1) unter Verwendung eines gemeinsamen externen Elements (11) im wesentlichen gleichzeitig entfernt wird.

11. Verfahren nach Anspruch 10, **dadurch gekennzeichnet, dass** das gemeinsame externe Element (11) jeweils durch eine Klebeverbindung (10, 10') mit den zu entfernenden Teilbereichen (6, 6') gekoppelt wird, wobei der Kleber (10, 10') insbesondere jeweils entsprechend den Abmessungen der zu entfernenden Teilbereiche (6, 6') auf diese aufgebracht wird.

12. Verfahren nach Anspruch 11, **dadurch gekennzeichnet, dass** der Kleber (10, 10') für eine Verbindung der außen liegenden Oberfläche (9, 9') des zu entfernenden Teilbereichs (6, 6') mit dem externen Element einem Aushärtevorgang unterworfen wird.

13. Verfahren nach einem der Ansprüche 10 bis 12, **dadurch gekennzeichnet, dass** das gemeinsame Element (11) von einer flächigen Materialschicht, insbesondere einer Folie gebildet wird.

14. Verfahren nach einem der Ansprüche 1 bis 9, **dadurch gekennzeichnet, dass** das externe Element von einem Draht (21) oder wenigstens einem stift- bzw. stabartigen Element (28), insbesondere aus Kunststoff, gebildet wird, welcher(s) mittels Löten, Schweißen, Reibschweißen, Bonden oder Kleben mit der außen liegenden Oberfläche (20, 27) des zu entfernenden Teilbereichs (16, 26) gekoppelt bzw. verbunden wird.

15. Verfahren nach Anspruch 14, **dadurch gekennzeichnet, dass** das externe Element (21, 28) durch eine automatisierte Handhabungseinrichtung (32) an der außen liegenden Oberfläche (21, 27) des zu entfernenden Teilbereichs (16, 26) positioniert wird und nach einer Verbindung mit der außen liegenden Oberfläche eine automatisierte Entfernung des zu entfernenden Teilbereichs (16, 26) durchgeführt wird.

16. Verwendung eines Verfahrens nach einem der Ansprüche 1 bis 15 zur Herstellung einer mehrlagigen Leiterplatte.

17. Verwendung nach Anspruch 16, zur Erzeugung von Hohlräumen, insbesondere dreidimensionalen Hohlräumen bzw. Kavitäten (14, 24, 31) in einer Leiterplatte.

18. Verwendung nach Anspruch 16, zur Erzeugung wenigstens eines Kanals (14, 24, 31) in einer Leiterplatte.

19. Verwendung nach Anspruch 16, zur Freistellung wenigstens eines Elements, insbesondere Registrierelements im Inneren bzw. in Innenlagen einer mehrlagigen Leiterplatte.

20. Verwendung nach Anspruch 16, zur Herstellung von abgesetzten und/oder stufenförmig ausgebildeten Teilbereichen (14, 24, 31) einer Leiterplatte.

21. Verwendung nach Anspruch 16, zur Herstellung einer starr-flexiblen Leiterplatte.

## Claims

1. A method for the production of a circuit board (1, 15, 25) involving the removal of a subregion (6, 6', 16, 26) thereof, wherein at least two layers or plies (2, 3, 4, 5) of the circuit board (1, 15, 25) are interconnected, and the subregion (6, 6', 16, 26) to be removed is prevented from being connected to an adjacent ply of the circuit board (1, 15, 25) by providing or applying an adhesion-preventing material (7, 17, 30), and edge regions of the subregion (6, 6', 16, 26) to be removed are separated from adjoining regions of the circuit board (1, 15, 25), **characterised in that**, following a separation or severing (8, 19) of the edge regions, an external surface (9, 20, 27) of the subregion (6, 6', 16, 26) to be removed is connected to an external element (11, 21, 28), and **in that** the subregion (6, 6', 16, 26) to be removed is separated from the adjacent ply of the circuit board (1, 15, 25) by a raising or displacement the external element (11, 21, 28).

2. The method according to Claim 1, **characterised in that** a crack formation (33) and/or a detachment from the subregion (6) of the circuit board (1) to be removed is induced in an edge region or subregion in or on the layer (7) made of the adhesion-preventing or bonding-preventing material and the subregion (6) to be removed is then removed.

3. The method according to Claim 2, **characterised in that** the crack formation (33) and/or detachment from the subregion (6) of the circuit board (1) to be removed in or on the layer (7) made of the adhesion-preventing material is/are produced by an introduction or forming of twists of the subregion (6) to be removed, said twists being produced as a result of a non-uniform stressing of said subregion to be removed.

4. The method according to Claim 1, 2 or 3, **characterised in that** the external element (11, 21, 28) is connected to the external surface (9, 20, 27) of the subregion (6, 6', 16, 26) to be removed by an adhesion, welding, soldering, bonding, friction welding or the like.

5. The method according to one of Claims 1 to 4, **characterised in that** the external element (11, 21, 28) is connected in an automated manner to the external surface (9, 20, 27) of the subregion (6, 6', 16, 26) to be removed.

6. The method according to one of Claims 1 to 5, **characterised in that** the subregion (6, 6', 16, 26) to be removed is removed in an automated manner.

7. The method according to one of Claims 1 to 6, **characterised in that** the edge regions of the subregion (6, 6', 16, 26) to be removed are defined and/or separated or severed in a manner known *per se* by a milling, carving or cutting, in particular laser cutting.

8. The method according to one of Claims 1 to 7, **characterised in that** the adhesion-preventing material (7, 17, 30) is formed in a manner known *per se* by a waxy paste, which, during a process of connecting at least two layers or plies of the circuit board, prevents an adhesion between the subregion (6, 6', 16, 26) to be removed subsequently and the adjacent ply of the circuit board (1, 15, 25).

9. The method according to one of Claims 1 to 8, **characterised in that** the connection between the external surface (20) of the subregion (16) to be removed and the external element (21) is regulated or controlled by a monitoring arrangement (36), which determines the position of the subregion (16) to be removed, in particular in an automated manner by means of an image processing method.

10. The method according to one of Claims 1 to 9, **characterised in that** a plurality of subregions (6, 6') to be removed, in particular from a plurality of circuit boards (1), are removed substantially simultaneously with use of a common external element (11).

11. The method according to Claim 10, **characterised in that** the common external element (11) is coupled by an adhesive connection (10, 10') to each of the subregions (6, 6') to be removed, wherein the adhesive (10, 10') is applied to the subregions (6, 6') to be removed in each case in accordance with the dimensions thereof.

12. The method according to Claim 11, **characterised in that** the adhesive (10, 10') is subjected to a curing process for a connection between the external surface (9, 9') of the subregion (6, 6') to be removed and the external element.

13. The method according to one of Claims 10 to 12, **characterised in that** the common element (11) is formed by a flat material layer, in particular a film.

14. The method according to one of Claims 1 to 9, **characterised in that** the external element is formed by a wire (21) or at least one pin-like or rod-like element (28), in particular made of plastic, which is coupled or connected by means of soldering, welding, friction welding, bonding or adhesion to the external surface (20, 27) of the subregion (16, 26) to be removed.

15. The method according to Claim 14, **characterised in that** the external element (21, 28) is positioned by means of an automated handling device (32) on the external surface (21, 27) of the subregion (16, 26) to be removed, and, following a connection to the external surface, an automated removal of the subregion (16, 26) to be removed is performed.

16. Use of a method according to one of Claims 1 to 15 for the production of a multi-ply circuit board.

17. The use according to Claim 16 for the production of voids, in particular three-dimensional voids or cavities (14, 24, 31) in a circuit board.

18. The use according to Claim 16 for the production of at least one channel (14, 24, 31) in a circuit board.

19. The use according to Claim 16 for the revealing of at least one element, in particular a registration element, in the interior or in inner plies of a multi-ply circuit board.

20. The use according to Claim 16 for the production of recessed and/or stepped subregions (14, 24, 31) of a circuit board.

21. The use according to Claim 16 for the production of a rigid/flexible circuit board.

## Revendications

1. Procédé de fabrication d'un circuit imprimé (1, 15, 25) par retrait d'une zone partielle (6, 6', 6, 26) de celui-ci, dans lequel au moins deux couches ou strates (2, 3, 4, 5) du circuit imprimé (1, 15 , 25) sont reliées les unes aux autres et une liaison de la zone partielle à retirer (6, 6', 16, 26) à une strate adjacente du circuit imprimé (1, 15, 25) est empêchée par disposition ou application d'une matière empêchant une adhérence (7, 17, 30) et des zones de bord de la zone partielle à retirer (6, 6', 16, 26) sont séparées des zones du circuit imprimé (1, 15, 25) qui y sont adjacentes, **caractérisé par le fait qu'**une surface extérieure (9, 20, 27) de la zone partielle à retirer (6, 6', 16, 26) est reliée à un élément externe (11, 21, 28) après une séparation ou un sectionnement (8, 19) des zones de bord et que la zone partielle à retirer (6, 6', 16, 26) est séparée de la strate adjacente du circuit imprimé (1, 15, 25) par un soulèvement ou éloignement de l'élément externe (11, 21, 28).

2. Procédé selon la revendication 1, **caractérisé par le fait que**, dans ou sur la couche (7) faite de la matière empêchant une adhérence ou un collage, dans une zone de bord ou partielle, une fissuration (33) et/ou un décollement de la zone partielle à retirer (6) du circuit imprimé (1) est induit et qu'ensuite la zone partielle à retirer (6) est retirée.

3. Procédé selon la revendication 2, **caractérisé par le fait que** la fissuration (33) et/ou le décollement de la zone partielle à retirer (6) du circuit imprimé (1), dans ou sur la couche (7) faite de la matière empêchant une adhérence, est ou sont provoqués par une introduction ou formation de torsions de la zone partielle à retirer (6) provoquées par une contrainte irrégulière de celle-ci.

4. Procédé selon l'une des revendications 1, 2 ou 3, **caractérisé par le fait que** la liaison de l'élément externe (11, 21, 28) à la surface extérieure (9, 20, 27) de la zone partielle à retirer (6, 6', 16, 26) est effectuée par un collage, un soudage, un brasage, un bonding, un soudage par friction ou similaires.

5. Procédé selon l'une des revendications 1 à 4, **caractérisé par le fait que** la liaison de l'élément externe (11, 21, 28) à la surface extérieure (9, 20, 27) de la zone partielle à retirer (6, 6', 16, 26) est effectuée automatiquement.

6. Procédé selon l'une des revendications 1 à 5, **caractérisé par le fait que** le retrait de la zone partielle à retirer (6, 6', 16, 26) est effectué automatiquement.

7. Procédé selon l'une des revendications 1 à 6, **caractérisé par le fait que** les zones de bord de la zone partielle à retirer (6, 6', 16, 26) sont définies et/ou séparées ou sectionnées d'une manière connue en soi par un fraisage, un rainurage, un découpage, en particulier un découpage par laser.

8. Procédé selon l'une des revendications 1 à 7, **caractérisé par le fait que** la matière empêchant une adhérence (7, 17, 30) est formée d'une manière connue en soi à partir d'une pâte cireuse, laquelle empêche une adhérence de la zone partielle à retirer par la suite (6, 6', 16, 26) à la strate adjacente du circuit imprimé (1, 15, 25) pendant un processus de liaison d'au moins deux couches ou strates du circuit imprimé.

9. Procédé selon l'une des revendications 1 à 8, **caractérisé par le fait que** la liaison de la surface extérieure (20) de la zone partielle à retirer (16) à l'élément externe (21) est régulée ou commandée par un disposition de surveillance (36), lequel en particulier de manière automatique détermine la position de la zone partielle à retirer (16) par un procédé de traitement d'image.

10. Procédé selon l'une des revendications 1 à 9, **caractérisé par le fait qu'**une pluralité de zones partielles à retirer (6, 6'), en particulier d'une pluralité de circuits imprimés (1), est retirée sensiblement en même temps par utilisation d'un élément externe commun (11).

11. Procédé selon la revendication 10, **caractérisé par le fait que** l'élément externe commun (11) est couplé aux zones partielles à retirer (6, 6') à chaque fois par une liaison adhésive (10, 10'), l'adhésif (10, 10') étant en particulier appliqué sur les zones partielles à retirer (6, 6') à chaque fois conformément aux dimensions de celles-ci.

12. Procédé selon la revendication 11, **caractérisé par le fait que** l'adhésif (10, 10') est soumis à un processus de durcissement pour une liaison de la surface extérieure (9, 9') de la zone partielle à retirer (6, 6') à l'élément externe.

13. Procédé selon l'une des revendications 10 à 12, **caractérisé par le fait que** l'élément commun (11) est formé d'une couche de matière plate, en particulier un film.

14. Procédé selon l'une des revendications 1 à 9, **caractérisé par le fait que** l'élément externe est formé d'un fil (21) ou d'au moins un élément (28) de type tige ou barre, en particulier en matière plastique, lequel est couplé ou relié à la surface extérieure (20, 27) de la zone partielle à retirer (16, 26) au moyen d'un brasage, d'un soudage, d'un soudage par friction, d'un bonding ou d'un collage.

15. Procédé selon la revendication 14, **caractérisé par le fait que** l'élément externe (21, 28) est positionné sur la surface extérieure (21, 27) de la zone partielle à retirer (26, 16) par un dispositif de manipulation automatisé (32) et qu'un retrait automatique de la zone partielle à retirer (16, 26) est effectué après une liaison à la surface extérieure.

16. Utilisation d'un procédé selon l'une des revendications 1 à 15 pour fabriquer un circuit imprimé multicouches.

17. Utilisation selon la revendication 16 pour générer des vides, en particulier des vides ou cavités tridimensionnels (14, 24, 31), dans un circuit imprimé.

18. Utilisation selon la revendication 16 pour générer au moins un canal (14, 24, 31) dans un circuit imprimé.

19. Utilisation selon la revendication 16 pour libérer au moins un élément, en particulier un élément d'enregistrement à l'intérieur ou dans les strates internes d'un circuit imprimé multicouches.

20. Utilisation selon la revendication 16 pour préparer des zones partielles (14, 24, 31) étagées et/ou en forme de gradins d'un circuit imprimé.

21. Utilisation selon la revendication 16 pour fabriquer un circuit imprimé rigide-souple.
